Europäisches Patentamt

European Patent Office

Office européen des brevets

(19)

(11) **EP 1 211 808 A1**

(12) ## DEMANDE DE BREVET EUROPEEN

| | |
|---|---|
| (43) Date de publication:<br>**05.06.2002 Bulletin 2002/23** | (51) Int Cl.[7]: **H03K 7/08**, H03K 5/04,<br>H04L 25/49 |

(21) Numéro de dépôt: **01204348.5**

(22) Date de dépôt: **14.11.2001**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **21.11.2000 FR 0015014**

(71) Demandeur: **Koninklijke Philips Electronics N.V.
5621 BA Eindhoven (NL)**

(72) Inventeur: **Bouvier, Stéphane,
c/o Société Civile S.P.I.D.
75008 Paris (FR)**

(74) Mandataire: **de la Fouchardière, Marie-Noelle
Société Civile "SPID"
156, Boulevard Haussmann
75008 Paris (FR)**

(54) **Dispositif de modulation de la largeur d'impulsion de signaux très hautes fréquences**

(57) La présente invention concerne un dispositif de modulation MD destiné délivrer un signal de sortie Vout composé d'une succession d'impulsions.
Selon l'invention, un tel dispositif inclut :

. deux transistors T1 et T2, montés en paire différentielle,
. un élément capacitif C connecté entre les deux transistors T1 et T2,
. des moyens de réglage LC1, LC2, UC1, UC2, pour ajuster le potentiel d'au moins une des bornes de l'élément capacitif C, et
. des moyens de comparaison CMP fournissant le signal de sortie Vout, représentatif du signe de la tension Vc présente aux bornes de l'élément capacitif C.

L'invention permet, au moyen d'une structure simple et essentiellement analogique, un contrôle rapide et flexible de la largeur des impulsions du signal de sortie Vout.

FIG.1

**Description**

La présente invention concerne un dispositif de modulation destiné à recevoir un signal d'entrée composé d'une succession d'impulsions de largeur prédéterminée et à délivrer un signal de sortie composé d'une succession d'impulsions de largeur ajustable.

Un tel dispositif est connu de la demande de brevet japonais publiée sous le numéro JP 01202916. Le dispositif de modulation qui y est décrit est destiné à recevoir un signal d'entrée de nature asymétrique, et est muni d'une première et d'une deuxième branche permettant respectivement de diminuer ou d'augmenter la largeur des impulsions du signal de sortie du dispositif. A cet effet, lesdites branches comportent un assortiment de cellules à retard et de portes logiques, une sélection de celle des branches qui doit être activée étant rendue possible grâce à un multiplexeur.

Le dispositif de modulation connu possède une structure complexe, qui présente un certain nombre d'inconvénients.

Tout d'abord, il est inévitable que chacune des portes logiques incluse dans ce dispositif induise un retard dans les signaux qui les traversent. Si de tels retards peuvent être ignorés ou négligés dans des applications où les signaux à traiter ont une fréquence faible ou relativement peu élevée, par exemple de l'ordre du kiloHertz ou du MégaHertz, ces retards, qui sont typiquement de l'ordre de la nanoseconde ou du dixième de nanoseconde dans l'état actuel de la technique, auront un effet néfaste pour le traitement de signaux ayant une fréquence très élevée, par exemple de l'ordre du GigaHertz.

De plus, les cellules à retard mises en oeuvre dans le dispositif connu doivent être parfaitement appairées pour rendre possible une absence volontaire de modulation de la largeur d'impulsion du signal de sortie, situation dans laquelle les deux branches doivent alternativement introduire un même déphasage dans ledit signal de sortie. Un tel appairage est très difficile, et donc coûteux, à réaliser en pratique.

Par ailleurs, il est souvent préférable, particulièrement lorsque la fréquence des signaux à traiter est très élevée, d'utiliser des structures différentielles qui présentent de meilleurs taux de réjection en mode commun et des facteurs d'immunité au bruit plus élevés que des structures asymétriques telles celle du dispositif connu. A cet effet, la structure décrite ci-dessus devra être dupliquée, ce qui augmentera encore la complexité du dispositif connu, lorsque configuré en mode différentiel, et par conséquent son coût de production, tout en rendant un tel dispositif de modulation encore plus sensible aux inconvénients précités.

L'invention a pour but de remédier à ces inconvénients en proposant un dispositif de modulation présentant une structure simple, dépourvue de portes logiques et de cellules à retard, et permettant un traitement de signaux différentiels à très haute fréquence.

En effet, selon l'invention, un dispositif de modulation conforme au paragraphe introductif inclut :

- un premier et un deuxième transistor montés en paire différentielle, dont la conduction est pilotée au moyen du signal d'entrée du dispositif,
- un élément capacitif muni d'une première et d'une deuxième borne, respectivement connectées aux premier et deuxième transistors,
- des moyens de réglage pour ajuster un potentiel d'au moins une desdites bornes, et
- des moyens de comparaison destinés à délivrer le signal de sortie du dispositif, dont une valeur instantanée est représentative du signe d'une tension prélevée aux bornes de l'élément capacitif.

Dans le dispositif conforme à l'invention, des transitions quasi-simultanées qui délimitent les impulsions du signal d'entrée génèrent des pentes dans des courbes représentatives de l'évolution des potentiels des bornes de l'élément capacitif, du fait des charges et décharges progressives de celui-ci. A chaque croisement desdites courbes de potentiel correspondra une transition du signal de sortie du dispositif de modulation.

Les moyens de réglage permettent, en provoquant un décalage du potentiel d'au moins une des bornes de l'élément capacitif, de décaler dans le temps les instants où de tels croisements se produisent, et donc d'ajuster la largeur des impulsions du signal de sortie du dispositif.

Le traitement du signal d'entrée est donc essentiellement analogique dans le dispositif selon l'invention, ce qui lui confère une grande rapidité et le rend particulièrement bien adapté à des applications «très hautes fréquences».

De plus, le dispositif selon l'invention possède une structure simple et essentiellement symétrique, ce qui lui permet de traiter des signaux différentiels et lui confère un fort taux de réjection en mode commun et un facteur d'immunité au bruit élevé.

Dans un mode de réalisation particulier de l'invention, les moyens de réglage incluent des moyens de diminution et des moyens d'augmentation de potentiel, associés à au moins une des bornes de l'élément capacitif.

Ce mode de réalisation permet de contrôler de manière simple et flexible les croisements des courbes de potentiel, et donc la largeur des impulsions du signal de sortie du dispositif de modulation selon l'invention.

Dans un mode de réalisation particulièrement avantageux de l'invention, des moyens de diminution et des moyens d'augmentation de potentiel seront associés à chacune des bornes de l'élément capacitif, ce qui autorisera une plus grande flexibilité et une meilleure résolution du réglage de la largeur des impulsions du dispositif de modulation selon l'invention.

Ainsi qu'exposé précédemment, le dispositif de modulation selon l'invention est particulièrement bien adapté au traitement de signaux ayant une fréquence très élevée. Il sera donc avantageusement mis en oeuvre pour piloter des émetteurs d'informations à très haut débit, comme des émetteur de signaux lumineux dans des systèmes de télécommunication optique ayant des débits qui se mesurent en Gigabits/seconde. L'invention concerne ainsi un émetteur de signaux lumineux, incluant une source destinée à émettre un rayonnement lorsqu'un signal de contrôle de ladite source présente un état actif, émetteur incluant en outre un dispositif de modulation tel que décrit plus haut pour ajuster la durée des états actifs du signal de contrôle.

Dans une de ses applications les plus avantageuses, l'invention concerne également un système de télécommunication incluant :

. un émetteur de signaux lumineux tel que décrit ci-dessus,
. un récepteur de signaux lumineux, et
. un milieu de propagation permettant le transit desdits signaux depuis l'émetteur vers le récepteur.

L'invention sera mieux comprise à l'aide de la description suivante, faite à titre d'exemple non-limitatif et en regard des dessins annexés, dans lesquels :

- la figure 1 est un schéma fonctionnel décrivant un dispositif de modulation conforme à l'invention,
- la figure 2 est un ensemble de chronogrammes illustrant des évolutions de potentiels possibles dans un tel dispositif,
- la figure 3 un ensemble de chronogrammes illustrant d'autres évolutions de potentiels possibles dans un tel dispositif,
- la figure 4 est un schéma fonctionnel décrivant des moyens de diminution de potentiel inclus dans un dispositif de modulation conforme à un mode de réalisation particulier de l'invention,
- la figure 5 est un schéma fonctionnel décrivant des moyens d'augmentation de potentiel inclus dans un dispositif de modulation conforme à un autre mode de réalisation particulier de l'invention, et
- la figure 6 est un schéma de principe d'un système de télécommunication mettant en oeuvre l'invention.

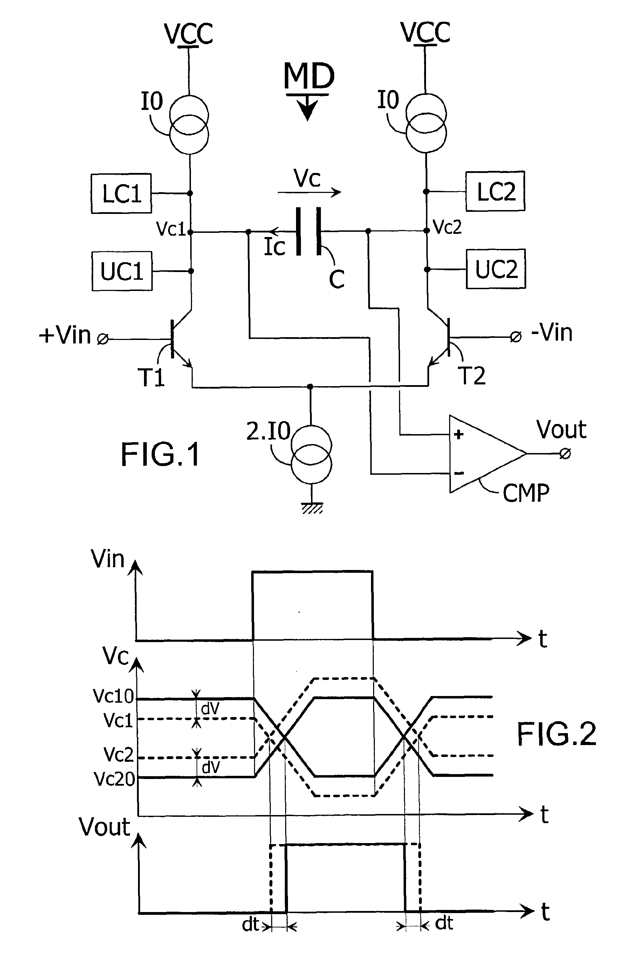

La figure 1 représente schématiquement un dispositif de modulation MD conforme à l'invention. Ce dispositif MD est destiné à recevoir un signal d'entrée Vin, composé d'une succession d'impulsions de largeur prédéterminée, et à délivrer un signal de sortie Vout composé d'une succession d'impulsions de largeur ajustable. Le dispositif MD inclut un premier et un deuxième transistor T1 et T2 montés en paire différentielle, dont la conduction est pilotée au moyen du signal d'entrée Vin.

Les transistors T1 et T2 sont, dans cet exemple, des transistors bipolaires dont des bases, collecteurs et émetteurs forment respectivement des bornes de polarisation, de transfert et de référence. Dans d'autres modes de réalisation, on pourra utiliser des transistors de type MOS, dont des grilles, drains et sources formeront respectivement lesdites bornes de polarisation, de transfert et de référence.

Chaque borne de transfert des premier et deuxième transistors T1 et T2 est connectée à une source de courant destinée à débiter un courant I0. La paire différentielle est polarisée au moyen d'une source de courant reliée aux bornes de référence des premier et deuxième transistors T1 et T2 et destinée à débiter un courant de valeur 2.I0.

Le dispositif de modulation MD conforme à l'invention inclut en outre un élément capacitif C muni d'une première et d'une deuxième borne, respectivement connectées aux bornes de transfert des premier et deuxième transistors T1 et T2.

Dans ce mode de réalisation de l'invention, le dispositif de modulation MD inclut des moyens de réglage pour ajuster les potentiels Vc1 et Vc2 des première et deuxième bornes de l'élément capacitif C. Ces moyens de réglage incluent des moyens de diminution de potentiel LC1 et LC2, et des moyens d'augmentation de potentiel UC1 et UC2, associés respectivement aux première et deuxième bornes de l'élément capacitif C.

Le dispositif de modulation MD inclut enfin des moyens de comparaison CMP destinés à délivrer le signal de sortie Vout, dont une valeur instantanée est représentative du signe d'une tension Vc prélevée aux bornes de l'élément capacitif C.

Dans ce dispositif de modulation, le premier transistor T1 est conducteur quand le signal d'entrée Vin est positif, et bloqué sinon. Le deuxième transistor T2 est conducteur quand le signal d'entrée Vin est négatif et bloqué sinon.

Lorsque survient un front montant du signal d'entrée Vin, l'élément capacitif C est parcouru par un courant Ic dans le sens représenté sur la figure, ce qui provoque une diminution progressive du potentiel Vc1 de la première borne de

**EP 1 211 808 A1**

l'élément capacitif C et une augmentation progressive du potentiel Vc2 de la deuxième borne dudit élément capacitif C. Lorsque survient un front descendant du signal d'entrée Vin, l'élément capacitif C est parcouru par un courant Ic en sens contraire à celui représenté sur la figure, ce qui provoque une diminution progressive du potentiel Vc2 de la deuxième borne de l'élément capacitif C et une augmentation progressive du potentiel Vc1 de la première borne dudit élément capacitif C. Ainsi, des transitions quasi-simultanées qui délimitent les impulsions du signal d'entrée Vin génèrent des pentes dans des courbes représentatives de l'évolution des potentiels Vc1 et Vc2 des première et deuxième bornes de l'élément capacitif C, du fait des charges et décharges progressives de celui-ci. A chaque croisement desdites courbes de potentiel, et donc à chaque annulation suivie d'un changement de signe de la tension Vc prélevée aux bornes dudit élément capacitif C correspondra une transition du signal de sortie Vout du dispositif de modulation.

Les moyens de réglage permettent, en provoquant des décalages des potentiels des bornes de l'élément capacitif, de décaler dans le temps les instants où de tels croisements se produisent, et donc d'ajuster la largeur des impulsions du signal de sortie Vout du dispositif de modulation MD.

La figure 2 est un ensemble de chronogrammes qui représente l'évolution de diverses grandeurs électriques présentes dans le dispositif de modulation décrit ci-dessus, afin de permettre un meilleure compréhension du fonctionnement de ce dispositif.

Les courbes Vc10 et Vc20 représentent en traits pleins l'évolution des potentiels des première et deuxième bornes de l'élément capacitif C lorsque les moyens de réglage sont inactifs.

Ainsi qu'expliqué ci-dessus, après que le signal Vin ait présenté un front montant signifiant le début d'une impulsion, le potentiel Vc10 de la première borne de l'élément capacitif diminue progressivement tandis que le potentiel Vc20 de la deuxième borne de l'élément capacitif diminue progressivement. Les diminutions et augmentations de potentiel ont été ici représentées sous une forme linéaire afin de faciliter la compréhension de l'ensemble de la figure. En réalité, ces diminutions et augmentations ont respectivement des formes logarithmique croissante et exponentielle décroissante.

Dans cet exemple , les moyens de comparaison sont câblés de sorte que tant que la tension Vc prélevée aux bornes de l'élément capacitif est négative, le signal de sortie Vout qu'elles délivrent présente un niveau logique "0", ledit signal de sortie Vout présentant un niveau logique "1" sinon. Ainsi, lorsque la différence de potentiel Vc20-Vc10 devient positive, le signal de sortie Vout passe du niveau logique "0" au niveau logique "1", ce qui délimite un début d'impulsion. Inversement, après que le signal Vin aura présenté un front descendant signifiant la fin d'une impulsion, le potentiel Vc10 de la première borne de l'élément capacitif augmentera progressivement tandis que le potentiel Vc20 de la deuxième borne de l'élément capacitif diminuera progressivement. Lorsque la différence de potentiel Vc20-Vc10 redeviendra négative, le signal de sortie Vout passera du niveau logique "1" au niveau logique "0", ce qui délimitera une fin d'impulsion.

La figure 2 représente en traits pointillés l'évolution des potentiels Vc1 et Vc2 des première et deuxième bornes de l'élément capacitif lorsque les moyens de diminution de potentiel LC1 et les moyens d'augmentation de potentiel UC2 respectivement associés auxdites bornes sont actifs. Les courbes de potentiel associées auxdites bornes sont alors similaires à celles décrites précédemment, à ceci près que le potentiel Vc1 présente par rapport au potentiel Vc10 un décalage de -dV, tandis que le potentiel Vc2 présente par rapport au potentiel Vc20 un décalage de +dV. Un tel réglage a pour effet d'avancer d'une durée dt l'instant où la différence de potentiel Vc2-Vc1 devient positive, et donc l'instant où le signal de sortie Vout présente un front montant signifiant le début d'une impulsion.

Inversement, l'instant où la différence de potentiel Vc2-Vc1 devient négative, et donc l'instant où le signal de sortie Vout présente un front descendant signifiant le début d'une impulsion, est retardé d'une durée dt.

L'activation des moyens de réglage dans les conditions décrites ci-dessus permettent donc une augmentation d'une durée 2.dt de la largeur des impulsions du signal de sortie Vout.

Il est également envisageable de n'activer que les seuls moyens de diminution LC1 ou les seuls moyens d'augmentation UC2, ce qui permettra d'augmenter la largeur des impulsions d'une durée dt.

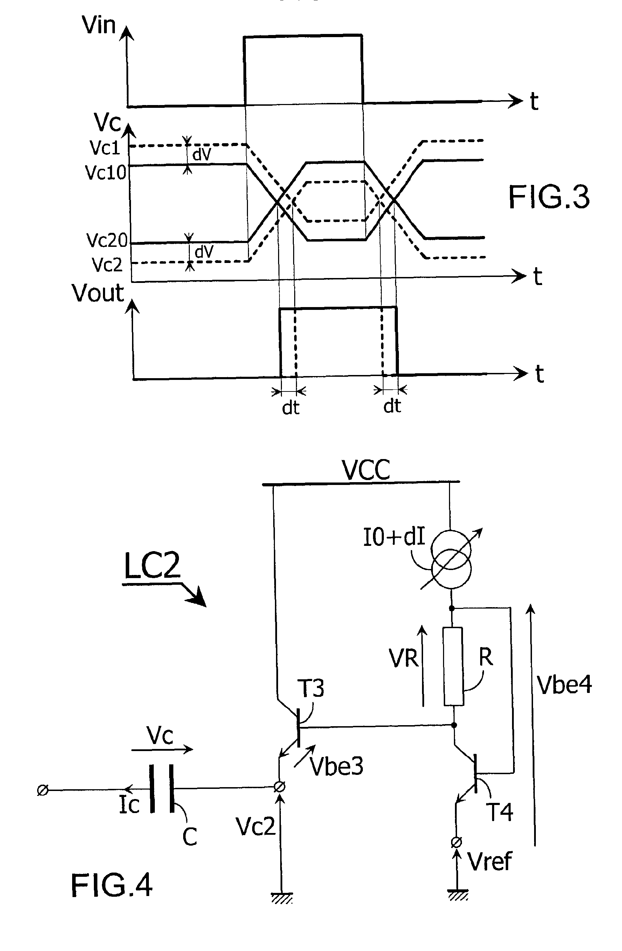

La figure 3 est un autre ensemble de chronogrammes qui représente l'évolution des mêmes grandeurs électriques que précédemment, dans le cas d'une configuration différente des moyens de réglage. Les éléments de cette figure qui sont communs à la figure précédente ont été munis des mêmes références et ne seront pas à nouveau décrits ici.

La figure 3 représente en traits pointillés l'évolution des potentiels Vc1 et Vc2 des première et deuxième bornes de l'élément capacitif lorsque les moyens d'augmentation de potentiel UC1 et les moyens de diminution de potentiel LC2 respectivement associés auxdites bornes sont actifs. Les courbes de potentiel associées auxdites bornes sont alors similaires à celles décrivant l'évolution des potentiels Vc10 et Vc20, à ceci près que le potentiel Vc1 présente par rapport au potentiel Vc10 un décalage de +dV, tandis que le potentiel Vc2 présente par rapport au potentiel Vc20 un décalage de -dV. Un tel réglage a pour effet de retarder d'une durée dt l'instant où la différence de potentiel Vc2-Vc1 devient positive, et donc l'instant où le signal de sortie Vout présente un front montant signifiant le début d'une impulsion. Inversement, l'instant où la différence de potentiel Vc2-Vc1 devient négative, et donc l'instant où le signal de sortie Vout présente un front descendant signifiant le début d'une impulsion, est avancé d'une durée dt.

L'activation des moyens de réglage dans les conditions décrites ci-dessus permettent donc une diminution d'une durée 2.dt de la largeur des impulsions du signal de sortie Vout.

Il est également envisageable de n'activer que les seuls moyens de diminution LC2 ou les seuls moyens d'augmentation UC1, ce qui permettra de diminuer la largeur des impulsions d'une durée dt.

La figure 4 est un schéma électrique qui représente un mode de réalisation possible des moyens LC2 de diminution du potentiel Vc2 de la deuxième borne de l'élément capacitif C. Il va de soi qu'il suffira de dupliquer une telle structure pour obtenir des moyens de diminution du potentiel Vc1 de la première borne de l'élément capacitif C. Dans l'exemple décrit ici, les moyens de diminution de potentiel LC2 mettent en oeuvre des transistors bipolaires, mais ils peuvent, conformément à ce qui a été exposé plus haut, être remplacés par des transistors de type MOS.

Les moyens de diminution de potentiel LC2 incluent dans cet exemple un troisième et un quatrième transistor T3 et T4 dont les émetteurs sont reliés à la deuxième borne de l'élément capacitif C et à une borne de référence de potentiel Vref, respectivement, troisième et quatrième transistors T3 et T4 dont les bases sont reliées entre elles via un élément résistif R, lequel est disposé en série avec le trajet principal de courant du quatrième transistor T4, c'est-à-dire dans cet exemple sa jonction collecteur-émetteur, ledit élément résistif R étant relié à une source de courant destiné à débiter un courant I0+dI de valeur réglable.

Le potentiel de référence Vref pourra par exemple être généré au moyen d'un générateur de type bandgap, selon une technique bien connue de l'homme du métier.

Le fonctionnement des moyens de diminution de potentiel peut être décrit comme suit :

Les tensions base-émetteur Vbe3 et Vbe4 des troisième et quatrième transistors T3 et T4 étant par construction sensiblement égales, et l'élément résistif R générant une tension VR=R.(I0+dI), le potentiel Vc2 de la deuxième borne de l'élément capacitif C peut être exprimé sous la forme :

$$Vc2=Vref+Vbe4-VR-Vbe3, \text{ soit encore } Vc2=Vref-R.(I0+dI)$$

Ainsi, en faisant varier d'une quantité de courant dI le courant débité par la source de courant, le potentiel Vc2 sera décalé d'une quantité -dV, où la valeur absolue de dV est égale à R.dI.

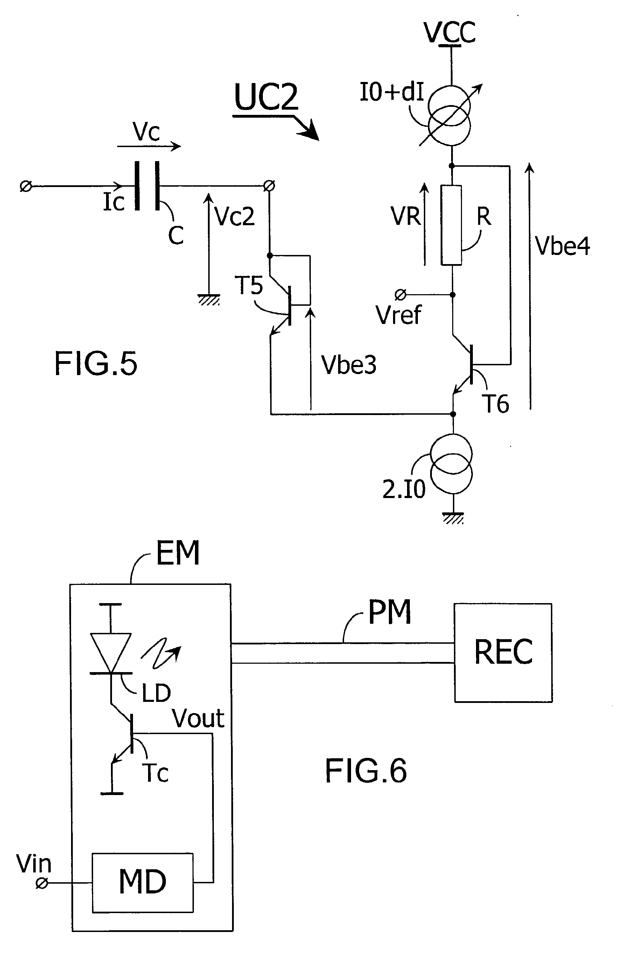

La figure 5 est un schéma électrique qui représente un mode de réalisation possible des moyens UC2 d'augmentation du potentiel Vc2 de la deuxième borne de l'élément capacitif C. Il va de soi qu'il suffira de dupliquer une telle structure pour obtenir des moyens d'augmentation du potentiel Vc1 de la première borne de l'élément capacitif C. Dans l'exemple décrit ici, les moyens d'augmentation de potentiel mettent en oeuvre des transistors bipolaires, mais ils peuvent, conformément à ce qui a été exposé plus haut, être remplacés par des transistors de type MOS.

Les moyens d'augmentation de potentiel LC2 incluent dans cet exemple un cinquième transistor T5 connecté en diode entre la deuxième borne de l'élément capacitif C et l'émetteur d'un sixième transistor T6, dont le collecteur est relié à une borne de référence de potentiel Vref d'une part, et à la base dudit sixième transistor T6 via un élément résistif R, d'autre part, ledit élément résistif R étant relié à une source de courant destiné à débiter un courant I0+dI de valeur réglable.

Le fonctionnement des moyens d'augmentation de potentiel peut être décrit comme suit :

Les tensions base-émetteur Vbe5 et Vbe6 des cinquième et sixième transistors T5 et T6 étant par construction sensiblement égales, et l'élément résistif R générant une tension VR=R.(I0+dI), le potentiel Vc2 de la deuxième borne de l'élément capacitif C peut être exprimé sous la forme :

$$Vc2=Vref+VR-Vbe4+Vbe3, \text{ soit encore } Vc2=Vref+R.(I0+dI)$$

Ainsi, en faisant varier d'une quantité de courant dI le courant débité par la source de courant, le potentiel Vc2 sera décalé d'une quantité +dV, où la valeur absolue de dV est égale à R.dI.

La figure 6 représente un système de télécommunication dans lequel l'invention est mise en oeuvre. Ce système inclut :

.     un émetteur de signaux lumineux EM,
.     un récepteur de signaux lumineux REC, et
.     un milieu de propagation PM permettant le transit desdits signaux depuis l'émetteur vers le récepteur.

Le milieu de propagation pourra par exemple être une fibre optique, le récepteur REC pouvant quant à lui comporter une photodiode capable de détecter les signaux émis par l'émetteur EM. Dans l'exemple décrit ici, ledit émetteur EM inclut une source LD, par exemple une diode laser, destinée à émettre un rayonnement lorsqu'un signal de contrôle Vout de ladite source présente un état actif. Dans cet exemple, le signal de contrôle Vout pilote la conduction d'un transistor Tc servant d'interrupteur. L'émetteur EM inclut en outre un dispositif de modulation MD conforme à l'invention pour ajuster la durée des états actifs du signal de contrôle Vout.

Les propriétés particulières du dispositif de modulation MD selon l'invention le rendent en effet particulièrement bien adapté pour contrôler l'émission de données optiques, dont le débit se chiffre en Gigabits/seconde.

**Revendications**

1. Dispositif de modulation destiné à recevoir un signal d'entrée composé d'une succession d'impulsions de largeur prédéterminée et à délivrer un signal de sortie composé d'une succession d'impulsions de largeur ajustable, incluant :

   . un premier et un deuxième transistor montés en paire différentielle, dont la conduction est pilotée au moyen du signal d'entrée du dispositif,
   . un élément capacitif muni d'une première et d'une deuxième borne, respectivement connectées aux premier et deuxième transistors,
   . des moyens de réglage pour ajuster un potentiel d'au moins une desdites bornes, et
   . des moyens de comparaison destinés à délivrer le signal de sortie du dispositif, dont une valeur instantanée est représentative du signe d'une tension prélevée aux bornes de l'élément capacitif.

2. Dispositif de modulation selon le revendication 1, dans lequel les moyens de réglage incluent des moyens de diminution et des moyens d'augmentation de potentiel, associés à au moins une des bornes de l'élément capacitif.

3. Dispositif de modulation selon le revendication 2 dans lequel les moyens de diminution de potentiel associés à au moins une borne de l'élément capacitif incluent un troisième et un quatrième transistor dont des bornes de référence sont reliées à ladite borne de l'élément capacitif et à une borne de référence de potentiel, respectivement, troisième et quatrième transistors dont des bornes de polarisation sont reliées entre elles via un élément résistif, lequel est disposé en série avec le trajet principal de courant du quatrième transistor, ledit élément résistif étant destiné à être parcouru par un courant de valeur réglable.

4. Dispositif de modulation selon le revendication 2 dans lequel les moyens d'augmentation de potentiel associés à au moins une borne de l'élément capacitif incluent un cinquième transistor connecté en diode entre ladite borne de l'élément capacitif et une borne de référence d'un sixième transistor, dont une borne de transfert est reliée à une borne de référence de potentiel d'une part, et à une borne de polarisation dudit sixième transistor via un élément résistif, ledit élément résistif étant destiné à être parcouru par un courant de valeur réglable.

5. Emetteur de signaux lumineux, incluant une source destinée à émettre un rayonnement lorsqu'un signal de contrôle de ladite source présente un état actif, émetteur incluant en outre un dispositif de modulation conforme à la revendication 1 pour ajuster la durée des états actifs du signal de contrôle.

6. Système de télécommunication incluant :

   . un émetteur de signaux lumineux conforme à la revendication 5,
   . un récepteur de signaux lumineux, et
   . un milieu de propagation permettant le transit desdits signaux depuis l'émetteur vers le récepteur.

FIG.1

FIG.2

7

Vin

t

Vc

Vc1

dV

Vc10

Vc20

dV

Vc2

t

FIG.3

Vout

t

dt        dt

LC2

VCC

I0+dI

VR         R

T3

Vbe4

Vc

Vbe3

Ic

C        Vc2

T4

Vref

FIG.4

## FIG.5

## FIG.6

Office européen
des brevets

**RAPPORT DE RECHERCHE EUROPEENNE**

Numéro de la demande

EP 01 20 4348

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 793 242 A (SAUER DON R) 11 août 1998 (1998-08-11) * le document en entier * | 1-4 | H03K7/08 H03K5/04 H04L25/49 |
| A | US 4 874 966 A (GEHRT HEINZ H ET AL) 17 octobre 1989 (1989-10-17) * le document en entier * | 1-4 | |
| A | US 5 498 992 A (LAI BENNY W H ET AL) 12 mars 1996 (1996-03-12) * le document en entier * | 1-4 | |
| A | EP 0 461 922 A (TOKYO SHIBAURA ELECTRIC CO) 18 décembre 1991 (1991-12-18) * abrégé; figure 1 * * page 8, ligne 25 - ligne 35 * | 1-4 | |
| A | US 4 694 504 A (PORTER DAVID R ET AL) 15 septembre 1987 (1987-09-15) * figure 1 * | 1,5,6 | |
| D,A | PATENT ABSTRACTS OF JAPAN vol. 013, no. 507 (E-845), 14 novembre 1989 (1989-11-14) & JP 01 202916 A (NEC CORP), 15 août 1989 (1989-08-15) * abrégé * | 1 | |
| A | US 4 779 074 A (WHITFORD ROWLAND E ET AL) 18 octobre 1988 (1988-10-18) * le document en entier * | 1 | |

**DOMAINES TECHNIQUES RECHERCHES (Int.Cl.7)**

H03K
H04B
H04L
G06G

Le présent rapport a été établi pour toutes les revendications

| Lieu de la recherche | Date d'achèvement de la recherche | Examinateur |
|---|---|---|
| LA HAYE | 26 mars 2002 | Jepsen, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**EP 1 211 808 A1**

**ANNEXE AU RAPPORT DE RECHERCHE EUROPEENNE
RELATIF A LA DEMANDE DE BREVET EUROPEEN NO.**          EP 01 20 4348

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-03-2002

| Document brevet cité au rapport de recherche | | Date de publication | Membre(s) de la famille de brevet(s) | | Date de publication |
|---|---|---|---|---|---|
| US 5793242 | A | 11-08-1998 | AUCUN | | |
| US 4874966 | A | 17-10-1989 | DE | 3702854 A1 | 11-08-1988 |
| | | | DE | 3706319 A1 | 08-09-1988 |
| | | | DE | 3871166 D1 | 25-06-1992 |
| | | | EP | 0277682 A2 | 10-08-1988 |
| | | | JP | 63248219 A | 14-10-1988 |
| US 5498992 | A | 12-03-1996 | JP | 6068286 A | 11-03-1994 |
| EP 0461922 | A | 18-12-1991 | JP | 4211508 A | 03-08-1992 |
| | | | DE | 69131531 D1 | 23-09-1999 |
| | | | DE | 69131531 T2 | 23-03-2000 |
| | | | EP | 0461922 A2 | 18-12-1991 |
| | | | KR | 9615677 B1 | 20-11-1996 |
| | | | US | 5384501 A | 24-01-1995 |
| | | | US | 5227681 A | 13-07-1993 |
| US 4694504 | A | 15-09-1987 | AU | 5761086 A | 11-12-1986 |
| JP 01202916 | A | 15-08-1989 | AUCUN | | |
| US 4779074 | A | 18-10-1988 | AU | 585622 B2 | 22-06-1989 |
| | | | AU | 5941686 A | 19-02-1987 |
| | | | BR | 8603442 A | 04-03-1987 |
| | | | CA | 1286408 A1 | 16-07-1991 |
| | | | DE | 3687379 D1 | 11-02-1993 |
| | | | DE | 3687379 T2 | 29-04-1993 |
| | | | EP | 0212898 A2 | 04-03-1987 |
| | | | ES | 556545 D0 | 16-10-1987 |
| | | | ES | 8800538 A1 | 01-01-1988 |
| | | | HK | 70493 A | 30-07-1993 |
| | | | IN | 164819 A1 | 10-06-1989 |
| | | | JP | 63018725 A | 26-01-1988 |
| | | | KR | 9400943 B1 | 04-02-1994 |
| | | | MX | 171571 B | 08-11-1993 |
| | | | SG | 54493 G | 09-07-1993 |

EPO FORM P0460

Pour tout renseignement concernant cette annexe : voir Journal Officiel de l'Office européen des brevets, No.12/82